# EUROPEAN PATENT APPLICATION

(11) **EP 0 762 490 A2**
(43) Date of publication of application: **12.03.1997**
(21) Application number: 96113634.8
(22) Date of filing: 26.08.1996
(51) Int. Cl.: H01L 21/336, H01L 21/265

(54) **Method of manufacturing a LDD-MOSFET**

(30) Priority: 25.08.1995 JP 217871/95
(71) Applicant: Oki Electric Industry Co., Ltd., Tokyo (JP)
(72) Inventor: Hirashita, Norio, Oki Electric Ind. Co., Ltd., Tokyo (JP); Okihara, Masao, Oki Electric Ind. Co., Ltd., Tokyo (JP)
(74) Representative: Betten & Resch

(57) **Abstract**

For the production of a semiconductor device, a gate oxide film (12) is formed on a silicon substrate (11). Polysilicon is deposited on the gate oxide film (12) and then subjected to photolithography. The polysilicon is patterned to form a gate electrode (13). Subsequently, a silicon oxide film or similar thin film (14) is formed on the entire surface of the laminate. The depth of an amorphous layer (15) to be formed by ion implantation later is calculated beforehand on the basis of the dose of ion implantation. The thin film (14) has its thickness selected to be four times or more greater than the calculated depth. Subsequently, arsenic ions (As⁺) are implanted in the substrate (11) via the thin film (14), thereby forming the amorphous layer (15) in the surface of the substrate (11). The resulting laminate is annealed in order to activate the impurity and recrystallize the amorphous layer (15). Because the [111] plane does not appear, only epitaxial grow in the direction perpendicular to the [100] direction occurs. Therefore, a diffusion layer (16) free from a crystal lattice defect at its edge is achieved.

## Description

### BACKGROUND OF THE INVENTION

### Field of the Invention

The present invention relates to a method of producing a semiconductor device and, more particularly, to a method of producing a semiconductor device and capable of freeing the impurity diffusion layer region of the device from crystal lattice defects.

### Description of the Background Art

Technologies relating to the above field of the art are disclosed in, e.g., "Three-dimensional solid-phase-epitaxial regrowth from As⁺-implanted Si", The Journal of Applied Physics, 65[6], 1989, pp. 2238-2242 (Document 1), "Defect formation in silicon at a mask edge during crystallization of amorphous implantation layer", The Journal of Applied Physics 6 6[10], 1989, pp.4723-4728 (Document 2), "Two-dimensional solid-phase epitaxial recovery of amorphous Si formed by ion implantation", The Journal of Crystal Growth, [99], 1990, pp.245-253 (Document 3), and "A Mechanism of the Sidewall Process Induced Junction Leakage Current of LDD Structure", The Journal of Electrochemical Society, [138], pp. 1439-1443 (Document 4).

It is a common practice with a semiconductor device to form a diffusion layer in a silicon substrate by ion implantation. A crystal lattice defect is, however, formed at the interface between an amorphous layer generated by high concentration ion implantation and a silicon crystal, as discussed in the above Documents 1, 2 and 3. If the defect extends from the diffusion layer region into the silicon substrate, a leak current increases to such a degree as to have fatal influence on the characteristic of the semiconductor device, as taught in Document 4. For example, an increase in leak current results in a decrease in charge holding time and an increase in power consumption. This will be described specifically, taking a MOSFET (Metal Oxide Semiconductor Field Effect Transistor) as an example.

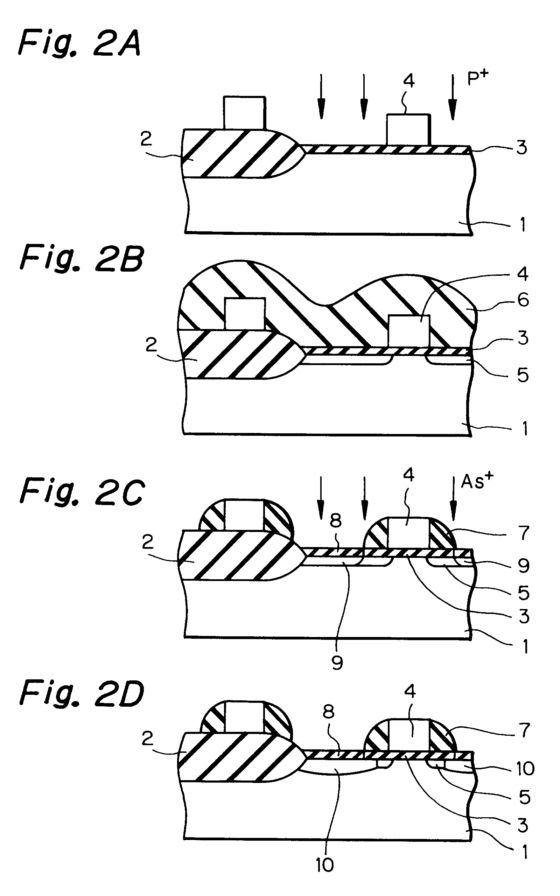

Referring to FIGS. 2A-2D, a conventional method of fabricating a semiconductor device is shown and adapted for an ordinary n-type MOSFET having a lightly doped drain (LDD) structure. As shown in FIG. 2A, a field oxide film 2 is formed on a silicon substrate 1 by LOCOS (Local Oxidation of Silicon) or similar technology. Then, a gate oxide film 3 is formed on the substrate 1 by gate oxidation. Polysilicon for implementing a gate electrode 4 is formed on the gate oxide film 3. Subsequently, phosphor (P⁺) ions are implanted in the substrate 1 in a low concentration, e.g., 1 x 10¹⁴/cm². During the ion implantation, the gate electrode 4 plays the role of a mask.

As shown in FIG. 2B, the above laminate is annealed in a non-oxidizing atmosphere in order to form a low concentration diffusion layer (N⁻) on the surface of the substrate 1. Then, a silicon oxide film 6 is formed on the entire surface of the laminate.

As shown in FIG. 2C, the silicon oxide film 6 is etched by anisotropic etching in order to form a sidewall 7. Then, a thin silicon oxide film 8 is formed by thermal oxidation. Subsequently, arsenic (As⁺) ions are implanted in a high concentration, e.g., 1 x 10¹⁵/cm² so as to lower the resistance of the diffusion layer 5. In this case, the sidewall 7 plays the role of a mask. As a result, a uniform amorphous layer 9 is formed in the surface of the substrate 1.

Finally, as shown in FIG. 2D, the laminate is annealed in a non-oxidizing atmosphere to crystalize the amorphous layer 9. Consequently, source/drain regions 10 implemented by a high concentration diffusion layer (N⁺) are formed.

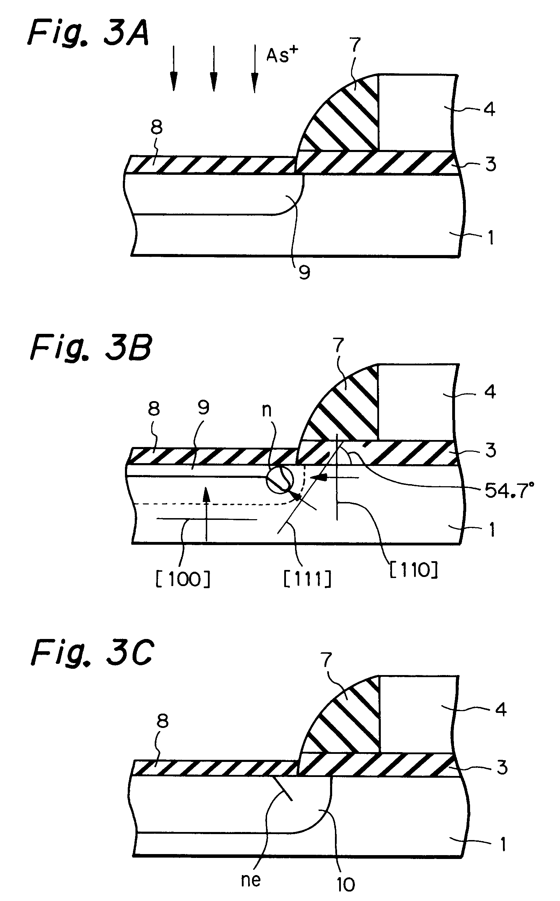

However, the problem with the MOSFET fabrication procedure shown in FIGS. 2A-2D is that during the annealing for forming the source/drain regions 10, a crystal lattice defect is generated at the interface between the amorphous layer 9 and the substrate 1, particularly in the vicinity of the edge of the sidewall 7. How the crystal lattice defect is generated will be described with reference to FIGS. 3A-3C.

As shown in FIG. 3A, a high concentration impurity (As⁺ in FIG. 3A) is implanted in the silicon to form the amorphous layer 9. Annealing effected after the implantation in a non-oxidizing atmosphere activates the impurity and recrystallizes the amorphous layer 9.

As shown in FIG. 3B, the amorphous layer 9 epitaxially grows mainly in the direction perpendicular to the interface between the layer 9 and the substrate 1, following the crystal structure of the substrate 1. However, in the region adjoining the edge of the sidewall 7, the epitaxial growth proceeds more rapidly in the direction perpendicular to the [100] direction and the direction perpendicular to the [110] direction than in the direction perpendicular to the [111] direction, i.e., in the direction angled 54.7 degrees to the surface of the substrate 1. As a result, a notch *n* is formed in the direction perpendicular to the [111] direction.

As shown in FIG. 3C, a crystal lattice defect *ne* remains in the source/drain region 10 because the recrystallization in the direction perpendicular to the [111] direction is far lower in speed than the recrystallization in the other directions. The defect *ne* grows and turns out a dislocation or a stacking fault due to a stress which the field oxide film 2 shown in FIGS. 2A-2D induces at the time of annealing.

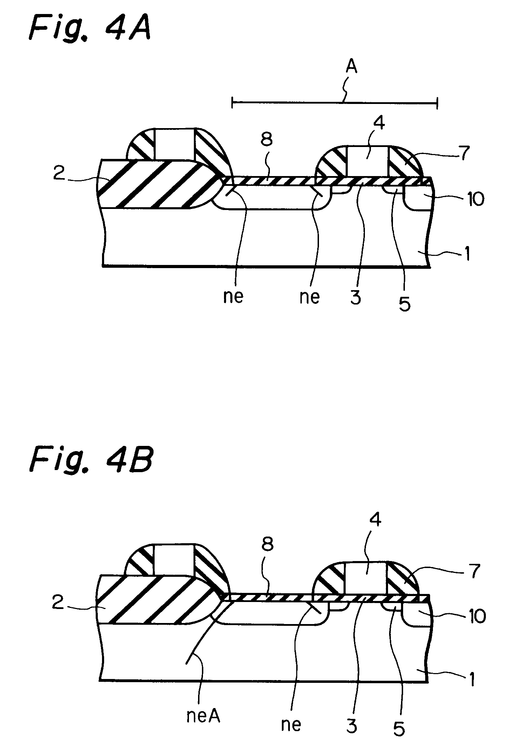

FIGS. 4A and 4B demonstrate how a dislocation is formed. As shown in FIG. 4A, the edge of the sidewall 7 exists in the active region A of the device in the vicinity of the field oxide film 2. As shown in FIG. 4B, the crystal lattice defect *ne* formed at the edge of the sidewall 7 grows to turn out a dislocation neA or a stacking fault due to a stress which the field oxide film 2 induces at the time of annealing, as stated above. Such a defect plays the role of a capture site which captures heavy metal or similar impurity. Therefore, when the defect extends from the diffusion layer region into the substrate, a current leak occurs along the defect. The current leak reduces the charge holding time, increases power consumption, and, in the worst case, reduces the yield of semiconductor devices.

### SUMMARY OF THE INVENTION

It is therefore an object of the present invention to provide a method of producing a semiconductor device and capable of freeing the device from crystal lattice defects.

In accordance with the present invention, a method of producing a semiconductor device begins with a step of forming a first insulation film on a semiconductor substrate. A mask is formed on the first insulation film except an impurity diffusion region included in the semiconductor substrate. A second insulation film is caused to to grow on the semiconductor substrate having the mask such that an amorphous layer to be formed by ion implantation later has a thickness equal to or less than 20 % of a thickness which it would have if the second insulation film were absent. Impurity ions are implanted from above the semiconductor substrate to thereby form the amorphous layer in the surface of the impurity diffusion region. Then, the semiconductor substrate is annealed at a preselected temperature to thereby crystallize the amorphous layer.

Further, in accordance with the present invention, a method of producing a semiconductor device begins with a step of forming a first insulation film on a semiconductor substrate. A mask is formed on the first insulation film except an impurity diffusion region included in the semiconductor substrate. A sidewall for insulation is formed on the periphery of the mask. A a second insulation film is formed on the semiconductor substrate having the sidewall such that an amorphous layer to be formed by ion implantation later has a thickness equal to or less than 20 % of a thickness which it would have if the second insulation film were absent. Impurity ions are implanted from above the semiconductor substrate by using the sidewall as a mask to thereby form the amorphous layer in the surface of the semiconductor substrate. Then, the semiconductor substrate is annealed at a preselected temperature to thereby crystallize the amorphous layer.

Moreover, in accordance with the present invention, a method of producing a semiconductor device begins with a step of forming a first insulation film in a region of a semiconductor substrate corresponding to a diffusion layer. A mask is formed on a region of the semiconductor substrate where an electrode is to be formed. A sidewall for insulation is formed on the periphery of the mask. Impurity ions are implanted in the region of the semiconductor substrate corresponding to the diffusion layer via the first insulation film. A second insulation film having the same coefficient of thermal expansion as the sidewall is formed on the mask, the sidewall, and the first insulation film. The semiconductor substrate having the second insulation film is annealed at a preselected temperature for crystallization.

### BRIEF DESCRIPTION OF THE DRAWINGS

The objects and features of the present invention will become more apparent from the consideration of the following detailed description taken in conjunction with the accompanying drawings in which:
FIGS. 1A-1C show a method of producing a semiconductor device and embodying the present invention;
FIGS. 2A-2D show a conventional method of producing a semiconductor device;
FIGS. 3A-3C demonstrate a mechanism of the generation of a crystal lattice defect;
FIGS. 4A and 4B show how the defect shown in FIGS. 3A-3C grows and turns out a dislocation;
FIG. 5 shows a specific configuration of an amorphous layer;
FIG. 6 plots depths at which the [111] plane is formed and determined by simulation;
FIGS. 7A-7C show an alternative embodiment of the present invention; and
FIGS. 8A-8E show another alternative embodiment of the present invention.

### DESCRIPTION OF THE PREFERRED EMBODIMENTS

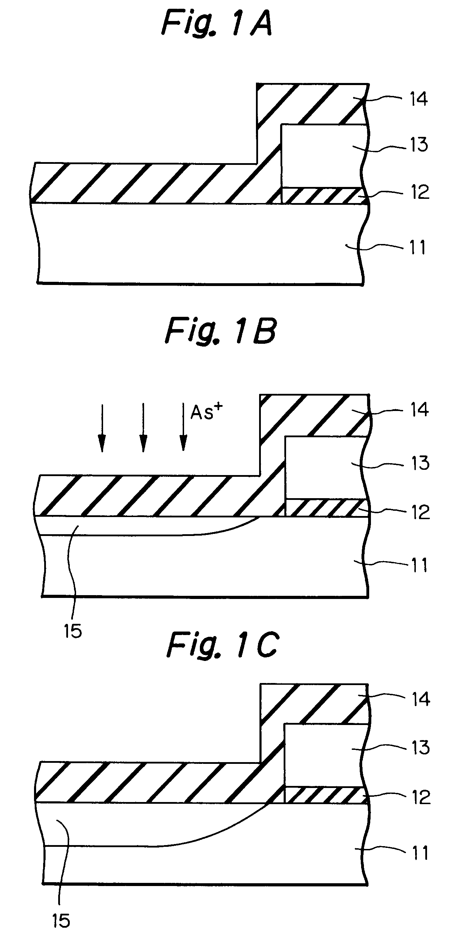

Referring to FIGS. 1A-1C, a method of producing a semiconductor and embodying the present invention will be described. The method begins with the formation of an insulation film, the formation of a mask, and the growth of the insulation film, as will be described with reference to FIG. 1A.

As shown in FIG. 1A, a gate oxide film 12 is formed on a silicon substrate 11 by gate oxidation. Polysilicon with low resistance, e.g., 1 x 10⁻³ Ωcm or below and to serve as a gate electrode is deposited on the gate oxide film 12. The resulting laminate is sequentially subjected to photolithography and anisotropic etching in order to pattern the polysilicon. As a result, the polysilicon turns out a gate electrode 13. Subsequently, a silicon oxide film or similar thin film 14 is formed on the entire surface of the laminate including the gate electrode 13 by CVD (Chemical Vapor Deposition) or similar technology.

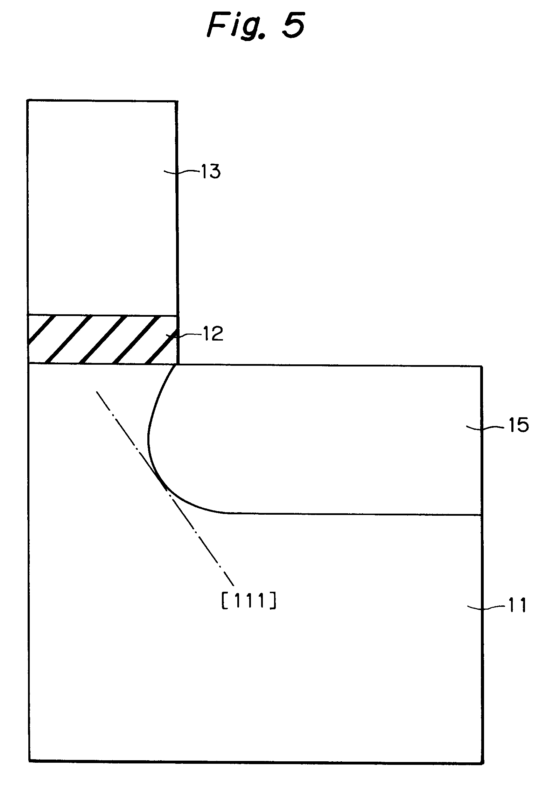

How the thickness of the thin film 14 is selected is as follows. FIG. 5 shows a specific configuration of an amorphous layer 15 determined by Monte Carlo simulation. The specific amorphous layer 15 was formed when arsenic was directly implanted in the silicon substrate 11 in a dose of 5 x 10¹⁵/cm² by 40 kV ion implantation, using the gate electrode 13 as a mask. While the thickness of the amorphous layer 15 depends on the dose of ion implantation, it is usually as great as the mean range of projection Rp of ion implantation plus diffusion one time to three times greater than Rp. As shown in FIG. 5, at the edge of the amorphous layer 15, the interface between the substrate 11 and the layer 15 forms an angle of 54.7 degrees between the interface and the surface of the substrate 11 at a depth which is about 80 % of the thickness of the layer 15. Thus, the interface forms the [111] plane.

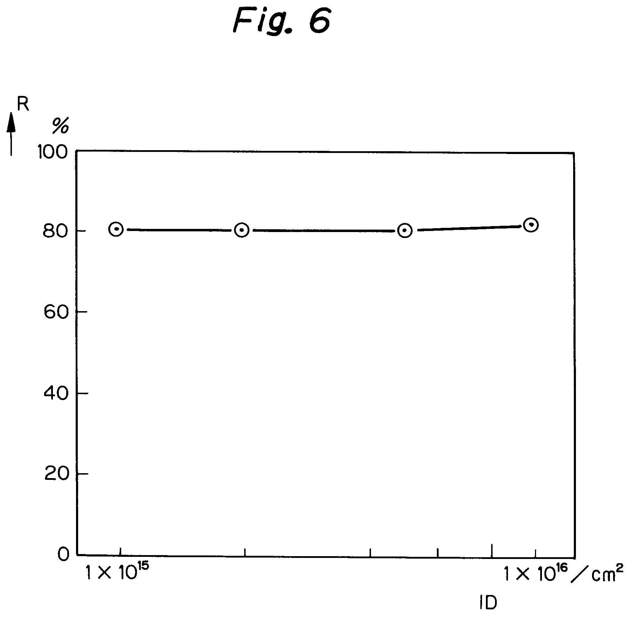

FIG. 6 shows a specific relation between the dose ID of ion implantation and the ratio R of the depth where the [111] plane is formed to the thickness of the amorphous layer 15, and the ratio R is determined by simulation. The ordinate and abscissa indicate the dose ID and the ratio R, respectively. The thickness of an amorphous layer increases with an increase in the dose of ion implantation, as generally accepted in the semiconductor art. On the other hand, as FIG. 6 indicates, the ratio R of the [111] plane depth to the thickness of an amorphous layer is about 80 % of the thickness of the amorphous layer without regard to the dose ID. It follows that if the thickness of the amorphous layer 15 is calculated beforehand on the basis of the dose of ion implantation, and if the thin film 14 having a thickness of more than about 80 % of the calculated thickness is formed on the substrate 11 by use of, e.g., a material identical in ion implantation obstruction ability with silicon, then the [111] plane will not appear on the interface at all even when high concentration ion implantation is effected. Of course, the ion implantation obstruction ability depends on the material forming the thin film 14. It is therefore necessary to translate the thickness of the thin film 14 into the obstruction ability of silicon, depending on the material of the thin film 14 used.

FIG. 1B shows ion implantation following the step shown in FIG. 1A. As shown, arsenic ions (As⁺) or similar impurity ions are implanted in the silicon substrate 11 in a high concentration via the thin film 14. The concentration may be as high as 1 x 10¹⁵/cm² or above by way of example. As a result, a continuous amorphous layer 15 is formed in the surface of the substrate 11.

FIG. 1C shows an annealing step to be executed after the ion implantation. As shown, the laminate produced by ion implantation is annealed at 500°C or above in a non-oxidizing atmosphere. The annealing activates the impurity and recrystallizes the amorphous layer 15. At this instant, because the [111] plane does not appear, only epitaxial growth occurs in the direction perpendicular to the [100] direction. Consequently, a diffusion layer 16 free from a crystal lattice defect at its edge is formed in a high concentration. The annealing step includes annealing the laminate at 800°C or above. This step diffuses the impurity trapped by the thin film 14 into the silicon substrate 11 and thereby further lowers the resistance of the diffusion layer 16.

As stated above, in the illustrative embodiment, the thin film 14 having a thickness four times or more greater than the depth of the amorphous layer 14 is formed on the silicon substrate 11 during the formation of the diffusion layer 16. Even when impurity ions (As⁺) are implanted in the substrate 11 in a high concentration via the thin film 11, such a thin film 14 confines the angle between the edge of the amorphous layer 15 formed in the substrate 11 and the surface of the substrate 11 in a range smaller than 54.7 degrees inclusive. This prevents the [111] plane from appearing and causes only epitaxial growth perpendicular to the [100] direction to occur. It follows that a crystal lattice defect at the edge of the amorphous layer 15 is obviated despite the annealing step. The diffusion layer 16 is therefore free from crystal lattice defects and provided with a high concentration. The semiconductor device with such a layer 16 reduces junction leak currents, increase the charge holding time of capacity, and saves power. These advantages enhance the yield of semiconductor devices.

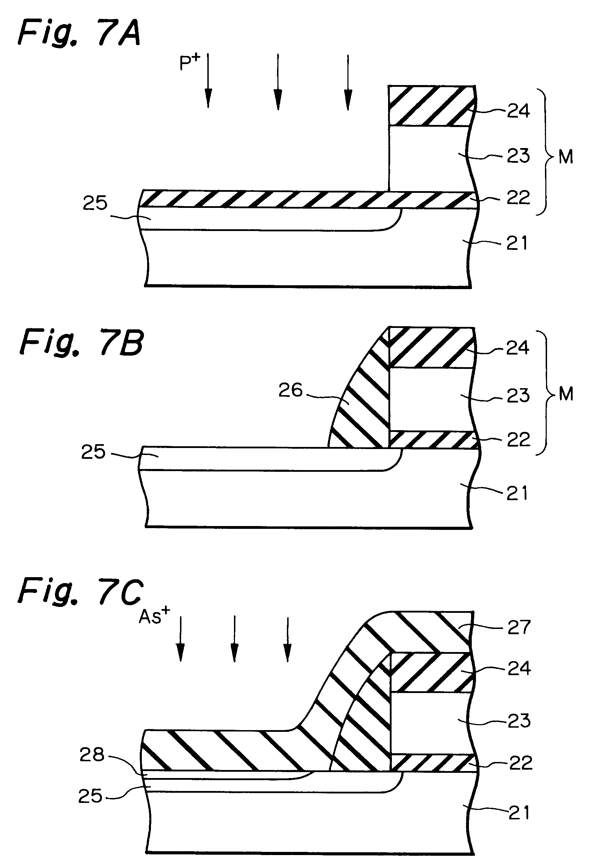

Referring to FIGS. 7A-7C, an alternative embodiment of the present invention is shown. This embodiment includes a unique step for the formation of a diffusion layer in an LDD type semiconductor device. The procedure to be described begins with the formation of a first insulation film and the formation of a mask, as shown in FIG. 7A. As shown, a first insulation film in the form of a gate oxide film 22 is formed on a silicon substrate 21 by gate oxidation. Low resistance polysilicon to constitute a gate electrode 23 is formed on the gate oxide film 22. Then, an oxide film 24 is formed on the gate electrode 23 and will serve as a mask in the event of etching. The resulting laminate is sequentially subjected to photolithography and anisotropic etching in order to pattern the polysilicon and oxide film 24. Subsequently, phosphor ions (P⁺) or similar impurity ions are implanted in the substrate 21 in a low concentration, using the patterned polysilicon and oxide film 24 as a mask M. The impurity concentration may be as low as 1 x 10¹⁴/cm⁻² or below by way of example. Then, the laminate is annealed in a non-oxidizing atmosphere in order to form a low concentration diffusion layer 25.

FIG. 7B shows the formation of a sidewall following the step shown in FIG. 7A. First, a silicon oxide film or similar insulation film, not shown, is deposited on the gate oxide film 22 and oxide film 24 to a substantial thickness. Then, the insulation film is etched by anisotropic etching in order to form a sidewall 26 on the periphery of the mask M.

The formation of the sidewall 26 is followed by the formation of a second insulation film and ion implantation which are shown in FIG. 7C. As shown, a second insulation film in the form of a thin film 27 is formed on the oxide film 24, diffusion layer 25 and sidewall 26. The thin film 27 may be implemented by a film of silicon oxide, amorphous silicon or polysilicon by way of example. Then, arsenic ions (As⁺) or similar impurity ions are implanted in the substrate 21 in a high concentration via the thin film 27. The impurity concentration may be as high as 1 x 10¹⁵/cm² or above by way of example. As a result, an amorphous layer 28 is formed in the surface of the substrate 21.

If desired, the thin film 27 may be implemented by a thin film of metal having a high melting point or its silicide or a thin TiN film or a combination thereof. Again, such a thin film must be provided with an optimal thickness because the ion implantation obstruction ability depends on the material, as stated in relation to the previous embodiment. The thickness of the thin film 27 should be equal to 80 % or more of the thickness of the amorphous layer 28 formed on the silicon substrate 21 by ion implantation. For this purpose, the thickness of the amorphous layer 28 is measured beforehand by simulation based on the dose of ion implantation.

After the step shown in FIG. 7C, the laminated is annealed at 500°C or above in a non-oxidizing atmosphere. The annealing activates the impurity and recrystallizes the amorphous layer 28. At this instant, because the [111] plane does not appear, only epitaxial growth occurs in the direction perpendicular to the [100] direction. Consequently, a diffusion layer free from a crystal lattice defect at its edge is formed. If use is made of a thin film of silicon, there can be obviated an occurrence that when the ion implantation seed is introduced into the thin film 27, atoms constituting the thin film 27 are introduced into the silicon substrate 21 due to knock-on and turn out an impurity which reduces the lifetime of carriers. The above annealing step includes annealing the laminate at 800°C or above. This part of annealing diffuses the impurity trapped by the thin film 27 into the substrate 21 and thereby further lowers the resistance of the diffusion layer 25.

As stated above, in this embodiment, the sidewall 26 is formed on the periphery of the mask M during the formation of the diffusion layer in an LDD type semiconductor device. Subsequently, the thin film 27 whose thickness is four times or more greater than the depth of the amorphous layer 28 is formed on the silicon substrate 21, as in the previous embodiment. In such a laminate structure, even when the impurity ions (As⁺) are implanted in a high concentration via the thin film 27, the angle between the amorphous layer 28 and the surface of the substrate 21 at the edge of the mask is as small as 54.7 degrees or below. This prevents the [111] plane from appearing and causes only epitaxial growth perpendicular to the [100] direction to occur. Consequently, a crystal lattice defect ascribable to annealing is prevented from occurring at the edge of the mask. This embodiment therefore also achieves the same advantages as the previous embodiment.

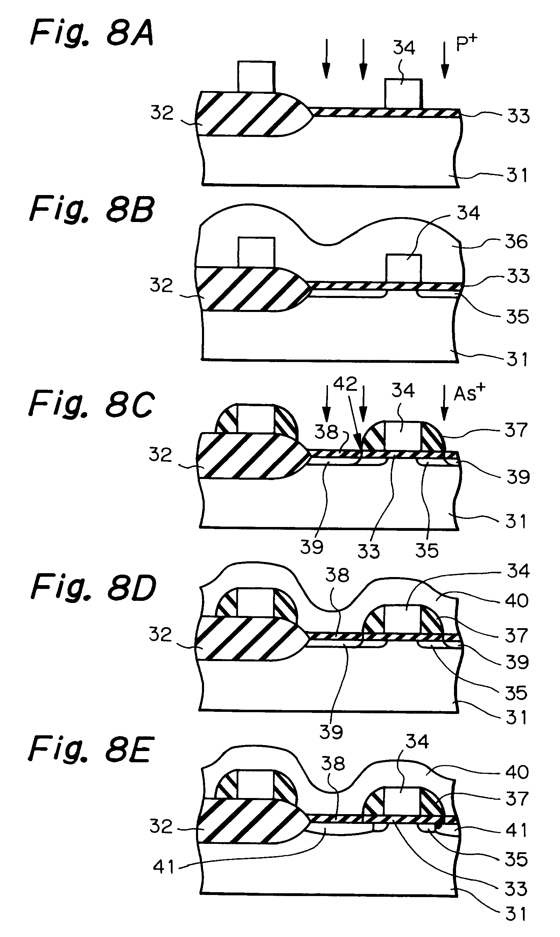

Another alternative embodiment of the present invention will be described with reference to FIGS. 8A-8E. The junction leak between a diffusion layer region and a substrate can also be reduced if a crystal lattice defect is prevented from growing as far as the depletion layer of a junction. A crystal lattice defect grows due to a shear stress. This embodiment suppresses the growth of a crystal lattice defect by reducing the shear stress acting on the edge of a mask. A semiconductor to be produced in this embodiment also has the LDD structure.

As shown in FIG. 8A, the procedure begins with the formation of a mask and a first insulation film. Specifically, a field oxide film 32 is formed on a silicon substrate 31 by LOCOS or similar technology. Then, a first insulation film in the form of a gate oxide film 33 is formed on the substrate 31 by gate oxidation. Polysilicon for forming a gate electrode 34 and having a low resistance is deposited on the gate oxide film 33. Phosphor ions (P⁺) are implanted in the substrate 31 in a low concentration with the gate electrode 34 serving as a mask.

Subsequently, the laminate shown in FIG. 8A is annealed in a non-oxidizing atmosphere, as shown in FIG. 8B. As a result, a diffusion layer (N⁻) 35 having a low concentration is formed in the surface of the substrate 31. Then, a silicon oxide film 36 is formed on the entire surface of the laminate.

FIG. 8C shows the formation of a sidewall and ion implantation following the step of FIG. 8B. As shown, a sidewall 37 is formed on the outer periphery of the gate electrode 34 by anisotropic etching. Then, a thin silicon oxide film 38 is formed by thermal oxidation. Subsequently, arsenic ions (As⁺) are implanted in a high concentration, e.g., 1 x 10¹⁵/cm² so as to lower the resistance of the diffusion layer 35 with the sidewall 37 playing the role of a mask. As a result, a uniform amorphous layer 39 is formed in the surface of the substrate 31.

As shown in FIG. 8D, a second insulation layer in the form of a thin film 40 is formed at less than 500°C on the entire surface of the laminate produced by the step of FIG. 8C. For the thin film 40, use is made of a material having the same coefficient of thermal expansion as the sidewall 37 or the edge of the mask.

Finally, as shown in FIG. 8E, the impurity implanted in the the substrate 31 is annealed at 500°C or above in order to form source/drain regions 41 implemented by a high concentration diffusion layer (N⁺). If the heat treatment of the impurity is effected at a low temperature, then fine defects are apt to remain in the diffusion layer and grow to form a noticeable slip dislocation due to a shear stress. Annealing the impurity at 800°C or above successfully obviates the above fine defects.

Generally, during annealing, a stress concentrates on the edge of the mask because the silicon substrate 31 and sidewall or mask 37 each has a particular coefficient of thermal expansion. If a fine defect exists in such a condition, the defect grows and turns out a noticeable slip dislocation due to a shear stress occurring on the surface of the substrate 31. In the illustrative embodiment, as shown in FIG. 8D, the thin film 40 having the same coefficient of thermal expansion as the mask 37 is formed on the entire surface of the substrate 31. Therefore, while the interface between the mask 37 and the substrate 31 exists in FIG. 8C (mask edges 42), it is absent in FIG. 8D. This reduces the concentration of the stress and thereby suppresses the growth of the crystal lattice defect which would bring about the junction leak.

As stated above, in this embodiment, the mask 37 and thin film 40 have the same coefficient of thermal expansion so as to reduce a shear stress which will occur at the mask edge during annealing. The embodiment therefore suppresses the growth of a crystal lattice defect and achieves the same advantages as the embodiment shown in FIG. 7A-7C.

In summary, it will be seen that the present invention provides a method of producing a semiconductor device and having various unprecedented advantages, as enumerated below.
(1) An insulation film exposed on a partly masked semiconductor substrate is caused to grow. The thickness of the insulation film is selected such that an amorphous layer to be formed by ion implantation later will have a thickness equal to or less than 20 % of a thickness which it would have if the insulation film were absent. Therefore, an ion implantation seed is partly introduced into the insulation film and allows the angle between the substrate and the amorphous layer to be reduced to 54.7 degrees (corresponding to the [111] plane) or below at the edge of a mask. This successfully reduces the occurrence of crystal lattice defects ascribable to epitaxial growth during annealing.
(2) A semiconductor device control method of the present invention is directly applicable to the production of LDD type MOSFETs.
(3) A second insulation film is formed by use of amorphous silicon or polysilicon. This insulation film obviates an occurrence that when the ion implantation seed is introduced into the insulation film, atoms constituting the insulation film enters the substrate due to knock-on and turns out an impurity which would reduce the lifetime of carriers.
(4) When the insulation film is implemented by a thin film of metal having a high melting point or its silicide, a thin TiN film or a combination thereof, a thin metal silicide film having a high melting point and formed during silicification can be used as the second insulation film. That is, the second insulation film can be formed during silicification effected to lower the resistance of the diffusion layer. Therefore, an extra step for the formation of the second insulation film is not necessary.
(5) Because annealing is effected at 800°C or above, the impurity introduced into the thin film can be diffused in silicone in a solid phase. It is therefore possible to lower the resistance of a high concentration diffusion layer.
(6) The second insulation layer has the same coefficient of thermal expansion as a sidewall. The sidewall reduces a shear stress to act on the substrate at the edge of the mask during annealing, thereby suppressing the growth of a crystal lattice defect.
(7) Because the growth of a crystal lattice defect is noticeably suppressed at 800°C and above, the annealing effected at 800°C or above reduces a leak current ascribable to the defect.

While the present invention has been described with reference to the particular illustrative embodiments, it is not to be restricted by the embodiments. It is to be appreciated that those skilled in the art can change or modify the embodiments without departing from the scope and spirit of the present invention. For example, in any one of the embodiments shown and described, the oxide film may be replaced with a nitride film or similar insulation film. In the embodiments, the thin films are each being shown and described as having a thickness four times or more greater than the thickness of the amorphous layer. Alternatively, because the thickness of an amorphous layer decreases with a decrease in the acceleration energy of ion implantation, the acceleration energy may be so controlled as to reduce the thickness of the amorphous layer to be formed on the silicon substrate. The present invention is practicable not only with high concentration arsenic ions but also any other high concentration impurity applicable to the production of semiconductor devices, e.g., P, BF or BF2.

## Claims

1. A method of producing a semiconductor device, CHARACTERIZED BY comprising the steps of:
(a) forming a first insulation film (12) on a semiconductor substrate (11);
(b) forming a mask (13) on said first insulation film (12) except an impurity diffusion region of said semiconductor substrate;
(c) causing a second insulation film (14) to grow on said semiconductor substrate (11) having said mask such that an amorphous layer (15) to be formed by ion implantation later has a thickness equal to or less than 20 % of a thickness which said amorphous layer (15) would have if said second insulation film (14) were absent;
(d) implanting impurity ions from above said semiconductor substrate (11) to thereby form said amorphous layer (15) in a surface of said impurity diffusion region; and
(e) annealing said semiconductor substrate (11) at a preselected temperature to thereby crystallize said amorphous layer (15).

2. A method in accordance with claim 1, CHARACTERIZED IN THAT step (e) comprises (f) annealing said semiconductor substrate (11) at a temperature higher than 800°C inclusive.

3. A method of producing a semiconductor device, CHARACTERIZED BY comprising the steps of:
(a) forming a first insulation film (22) on a semiconductor substrate (21);
(b) forming a mask (23) on said first insulation film (22) except an impurity diffusion region of said semiconductor substrate (21);
(c) forming a sidewall (26) for insulation on a periphery of said mask (23);
(d) forming a second insulation film (27) on said semiconductor substrate (21) having said sidewall (26) such that an amorphous layer (28) to be formed by ion implantation later has a thickness equal to or less than 20 % of a thickness which said amorphous layer (28) would have if said second insulation film(27) were absent;
(e) implanting impurity ions from above said semiconductor substrate (21) by using said sidewall (26) as a mask to thereby form said amorphous layer (28) in a surface of said semiconductor substrate (21); and
(f) annealing said semiconductor substrate (21) at a preselected temperature to thereby crystallize said amorphous layer (28).

4. A method in accordance with claim 3, CHARACTERIZED IN THAT said second insulation film (27) comprises a film of one of amorphous silicon and polysilicon.

5. A method in accordance with claim 3, CHARACTERIZED IN THAT said second insulation film (27) comprises one of a thin film of metal having a high melting point, a thin film of silicide of said metal, a thin TiN film, and a combination of said thin films.

6. A method in accordance with claim 3, CHARACTERIZED IN THAT step (f) comprises (g) annealing said semiconductor substrate (21) at a temperature higher than 800°C inclusive.

7. A method of producing a semiconductor device, CHARACTERIZED BY comprising the steps of:
(a) forming a first insulation film (33) in a region of a semiconductor substrate (31) corresponding to a diffusion layer;
(b) forming a mask (34) on a region of said semiconductor substrate (31) where an electrode is to be formed;
(c) forming a sidewall (37) for insulation on a periphery of said mask (34);
(d) implanting impurity ions in said region of said semiconductor substrate (31) corresponding to said diffusion layer via said first insulation film (33);
(e) forming a second insulation film (40) having a same coefficient of thermal expansion as said sidewall (37) on said mask (34), said sidewall (37), and said first insulation film (33); and
(f) annealing said semiconductor substrate (31) having said second insulation film (40) at a preselected temperature for crystallization.

8. A method in accordance with claim 7, CHARACTERIZED IN THAT step (f) comprises (g) annealing said semiconductor substrate (31) at a temperature higher than 800°C inclusive.
